# EUROPEAN PATENT SPECIFICATION

(11) **EP 2 088 446 B1**
(45) Date of publication and mention of the grant of the patent: **30.12.2015**
(21) Application number: 07831736.9
(22) Date of filing: 13.11.2007
(51) Int. Cl.: G01R 33/09, H04M 1/02

(54) **MAGNETIC DETECTOR AND ELECTRONIC DEVICE**
MAGNETDETEKTOR UND ELEKTRONISCHE ANORDNUNG
DÉTECTEUR MAGNÉTIQUE ET DISPOSITIF ÉLECTRONIQUE

(30) Priority: 15.11.2006 JP 2006308898
(43) Date of publication of application: 12.08.2009
(73) Proprietor: Alps Electric Co., Ltd., Ota-ku Tokyo 145-8501 (JP)
(72) Inventor: SASAKI, Yoshito, Tokyo 145-8501 (JP); SATO, Kiyoshi, Tokyo 145-8501 (JP)
(74) Representative: Klunker . Schmitt-Nilson . Hirsch
(86) International application number: PCT/JP2007/072006
(87) International publication number: WO 2008/059833

(56) References cited:
- DE-A1- 4 434 912
- JP-A- 08 226 960
- JP-A- 2004 029 007
- JP-A- 2005 214 900
- JP-A- 2005 214 900
- US-B1- 6 191 577

## Description

### Technical Field

The present invention relates to a magnetic detection device and an electronic apparatus, each enabling bipolar detection to be performed with a circuit arrangement simpler than in the related art.

### Background Art

As disclosed in the following Patent Document 1 and Patent Document 2, a flip cellular phone having a display case body and an operation case body connected to each other via a hinge portion detects opening of the display case body and the operation case body with the display case body not turned around to be in a rear side front position (hereinafter referred to as a first opening detection) and opening of the display case body and the operation case body with the display case body turned around to be in the rear side front position (hereinafter referred to as a second opening detection). To this end, the flip cellular phone includes a magnetic detector for performing the first opening detection and a magnetic detector for performing the second opening detection with one magnetic detector separately arranged from the other magnetic detector. More specifically, since the direction of the external magnetic field acting on the magnetic detection device is inverted from one opening detection to the other opening detection, the separate magnetic detectors for the first opening detection and the second opening detection are prepared for bipolar detection. Hall elements are typically used in the related art as a magnetoresistive effect element forming the magnetic detector.
Patent Document 1: Japanese Unexamined Patent Application Publication No. 2005-303688
Patent Document 2: Japanese Unexamined Patent Application Publication No. 2005-252539

A magnetoresistive sensor according to US 6 191 577 B1 includes a plurality of multilayered magnetoresistive films arranged in parallel. Each multilayered magnetoresistive film includes at least one pinned ferromagnetic layer and at least one free magnetic layer. Reversion of magnetization of the pinned ferromagnetic layer is pinned, whereas the vector of magnetization of the free ferromagnetic layer freely reverses in response to an external magnetic field. The vectors of magnetization of the pinned ferromagnetic layers in two adjacent multilayered magnetoresistive films are substantially antiparallel to each other.

DE 44 34 912 A1 discloses a sensor arrangement including four pairs of bridge elements in two parallel switched bridge branches. At least one bridge element exhibits a large magneto-resistive effect. Individual elements have different magnetic field sensitivities. All the elements are formed next to each other on one substrate. The substrate has a carrier structure and a coating. Three layers form a bias layer system. A lift-off technique is used to remove a structured varnish layer on the coating. The bridge elements are adjacent each other on the substrate.

To provide a low current consumption type multifunctional magnetic sensor JP 2005 214 900 A discloses a magnetic sensor having a magnetic detecting means, and a signal processing circuit for outputting a binary digital signal in response to a level of a detection signal therein is provided with the first output terminal brought into a high level when the detection signal is smaller than the first threshold value, and brought into a low level in the other case, and the second output terminal brought into a high level when the detection signal is smaller than the second threshold value different in a sign from that of the first threshold value, and brought into a low level in the other case.

### Disclosure of Invention

### Problems to Be Solved by the Invention

However, since the magnetic detector for performing the first opening detection and the magnetic detector for performing the second opening detection are separately arranged, the magnetic detection device including the two magnetic detectors becomes bulky, and is unsuitable for miniaturization. Also, the magnetic detection device becomes costly.

During the above-described first opening detection and second opening detection, the distance between a magnet and a magnetic detection device changes depending on the mounting positions of the magnet and the magnetic detection device even if the gap between the display case body and the operation case body remains unchanged. The magnitude of the external magnetic field acting on the magnetic detection device becomes different from the first opening detection to the second opening detection. If the detection sensitivity is set at the same level in each of the opening detections, an output timing of an ON-OFF signal becomes different from the first opening detection to the second opening detection. Also, the opening detection cannot be appropriately performed on a weaker external magnetic field acting on the magnetic detection device.

It is an object of the present invention to overcome the above-described problem and to provide a magnetic detection device and an electronic apparatus, each enabling bipolar detection to be performed with a circuit arrangement simpler than in the related art.

### Means for Solving the Problems

A magnetic detection device of the present invention includes a magnetoresistive effect element based on the magnetoresistive effect that an electrical resistance of the element varies in response to an external magnetic field, and a common circuit unit connected to the magnetoresistive effect element and enabled to detect both an external magnetic field in a (+) direction and an external magnetic field in a (-) direction opposite to the (+) direction in response to a change in the electrical resistance.

This arrangement enables the magnetic detection device to perform bipolar detection with a circuit arrangement simpler than in the related art. Also, the magnetic detection device can be miniaturized.

In accordance with the present invention, when the maximum magnetic field intensity of the external magnetic field in the (+) direction acting on the first magnetoresistive effect element is higher than the maximum magnetic field intensity of the external magnetic field in the (-) direction acting on the first magnetoresistive effect element, a detection sensitivity applied with the external magnetic field in the (+) direction operative is preferably set to be lower than a detection sensitivity applied with the external magnetic field in the (-) direction operative. Even when the maximum magnetic field intensity of the external magnetic field in the (+) direction is different from the maximum magnetic field intensity of the external magnetic field in the (-) direction in this way, both the external magnetic field in the (+) direction and the external magnetic field in the (-) direction can be appropriately detected by changing the detection sensitivity in accordance with the present invention.

In accordance with the present invention, the magnetoresistive effect element is preferably a first common magnetoresistive effect element having an electrical resistance changing in response to each of the external magnetic field in the (+) direction and the external magnetic field in the (-) direction, and a threshold value level of an output needed for the magnetic detection of the external magnetic field in the (+) direction and a threshold value level of an output needed for the magnetic detection of the external magnetic field in the (-) direction are preferably set in the circuit unit. One type of magnetoresistive effect element thus suffices and even the direction of the external magnetic field is detectable.

In accordance with the present invention, when the maximum magnetic field intensity of the external magnetic field in the (+) direction acting on the first magnetoresistive effect element is higher than the maximum magnetic field intensity of the external magnetic field in the (-) direction acting on the first magnetoresistive effect element acting on the first magnetoresistive effect element, a level difference between a reference level of an output in response to no magnetic field state and the threshold value level of the output needed for the magnetic detection of the external magnetic field in the (+) direction is preferably set to be larger than a level difference between the reference level and the threshold value level of the output needed for the magnetic detection of the external magnetic field in the (-) direction. Even when the maximum magnetic field intensity of the external magnetic field in the (+) direction is different from the maximum magnetic field intensity of the external magnetic field in the (-) direction, both the external magnetic field in the (+) direction and the external magnetic field in the (-) direction can be appropriately detected by changing the level differences of the threshold value levels with respect to the reference level in accordance with the present invention.

In accordance with the present invention, the magnetoresistive effect elements may include a second magnetoresistive effect element having an electrical resistance changing in response to the external magnetic field in the (+) direction and a third magnetoresistive effect element having an electrical resistance changing in response to the external magnetic field in the (-) direction, and the circuit unit may detect both the external magnetic field in the (+) direction in response to a change in an electrical resistance of the second magnetoresistive effect element and the external magnetic field in the (-) direction in response to a change in an electrical resistance of the third magnetoresistive effect element.

Each of the second magnetoresistive effect element and the third magnetoresistive effect element may have a laminate structure including an antiferromagnetic layer, a pinned magnetic layer, a non-magnetic intermediate layer, and a free magnetic layer, and when the maximum magnetic field intensity of the external magnetic field in the (+) direction acting on the second magnetoresistive effect element is higher than the maximum magnetic field intensity of the external magnetic field in the (-) direction acting on the third magnetoresistive effect element, the absolute value of an interlayer coupling magnetic field Hin2 acting between the pinned magnetic layer and the free magnetic layer of the second magnetoresistive effect element is preferably set to be larger than the absolute value of an interlayer coupling magnetic field Hin3 acting between the pinned magnetic layer and the free magnetic layer of the third magnetoresistive effect element. Even when the maximum magnetic field intensity of the external magnetic field in the (+) direction is different from the maximum magnetic field intensity of the external magnetic field in the (-) direction, both the external magnetic field in the (+) direction and the external magnetic field in the (-) direction can be appropriately detected by changing magnetic field sensitivity with the magnitude of the interlayer coupling magnetic field Hin of the magnetoresistive effect elements changed in accordance with the present invention. In accordance with the present invention, an electronic apparatus includes a first main body and a second main body, with the first main body and the second main body connected to each other in a manner that allows the first and second main bodies to flip open and shut, and with the second main body supported in a manner that allows the second main body to turn around to be in a rear side front position. A magnet is mounted on one of the first main body and the second main body, and one of the above-described magnetic detection devices is mounted on the other of the first main body and the second main body. When the first main body and the second main body flip are flipped shut in a first opening detection with the second main body not turned around, the magnet and the magnetic detection device move closer in distance to each other and the external magnetic field in one of the (+) direction and the (-) direction emitted from the magnet is detected. When the first main body and the second main body are flipped shut in a second opening detection with the second main body turned around, the magnet and the magnetic detection device move closer in distance to each other and the other external magnetic field in a direction opposite to the direction in the first opening detection emitted from the magnet is detected.

In accordance with the present invention, the electronic apparatus appropriately performs each of the first opening detection and the second opening detection with a simple circuit arrangement.

During the first opening detection and second opening detection, the distance between the magnet and the magnetic detection device changes depending on the mounting positions of the magnet and the magnetic detection device even if the gap between the display case body and the operation case body remains unchanged. As a result, the magnitudes of the external magnetic field in the (+) direction and the external magnetic field in the (-) direction acting on the magnetic detection device become different. In such a case, a signal can be output at the same timing during the first opening detection and the second opening detection by setting the detection sensitivity applied when the external magnetic field in the (+) direction is operative different from the detection sensitivity applied when the external magnetic field in the (-) direction is operative.

### Advantages

The present invention provides a magnetic detection device that enables bipolar detection with a simpler circuit structure than in the related art.

### Best Mode for Carrying Out the Invention

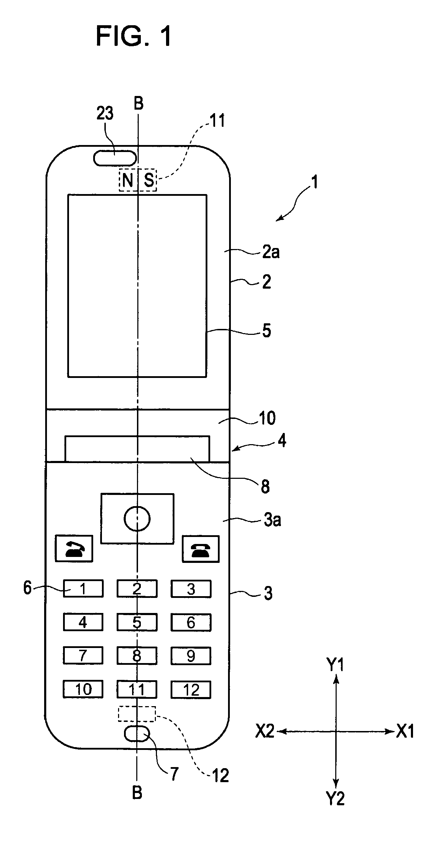

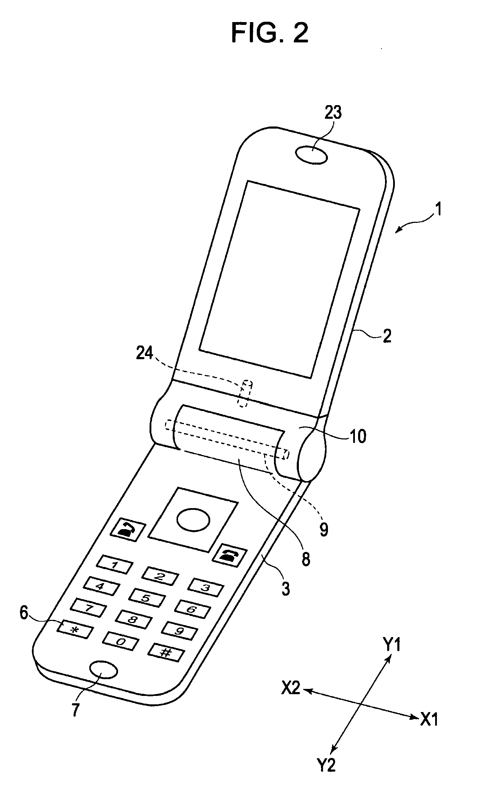

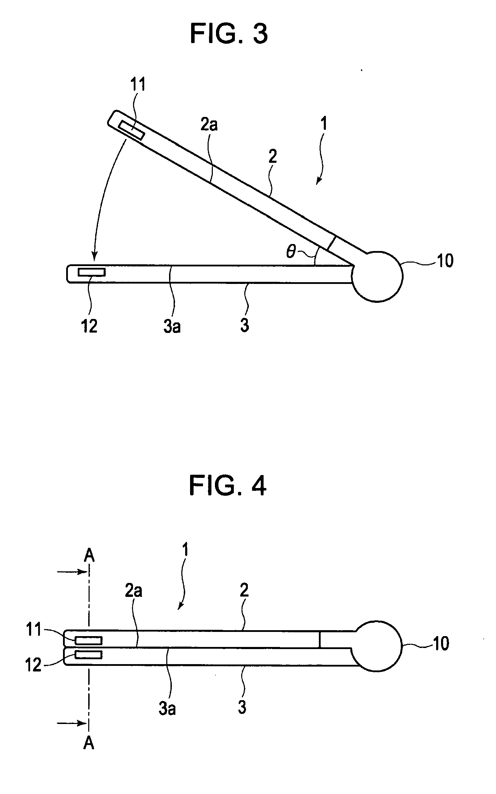

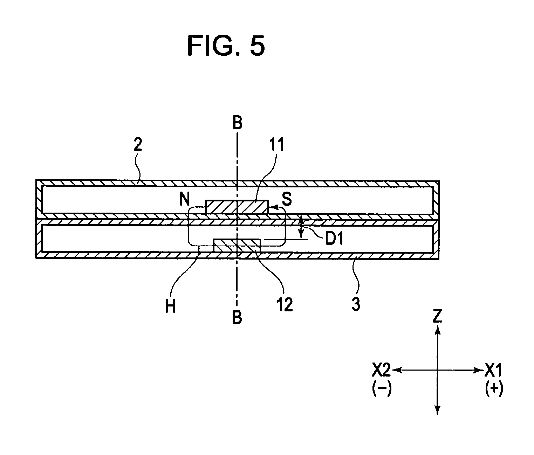

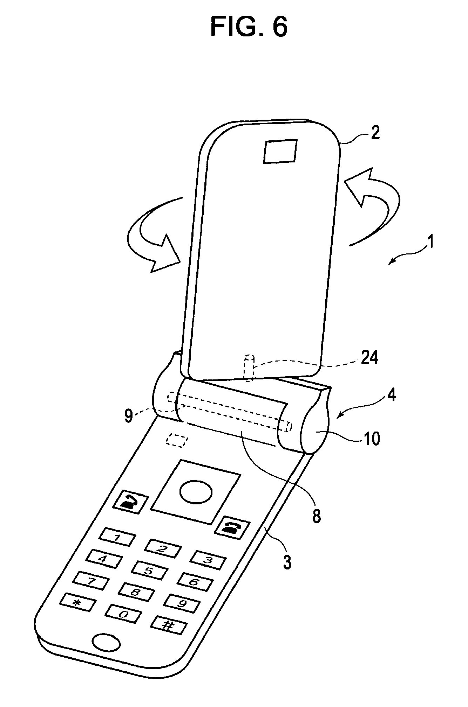

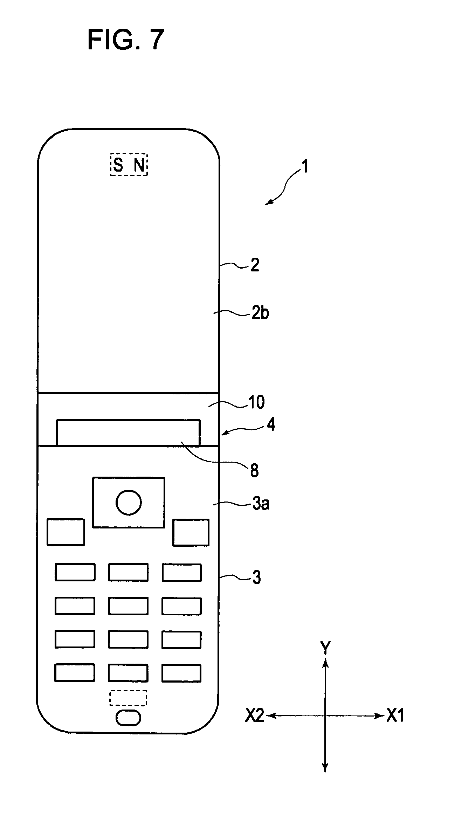

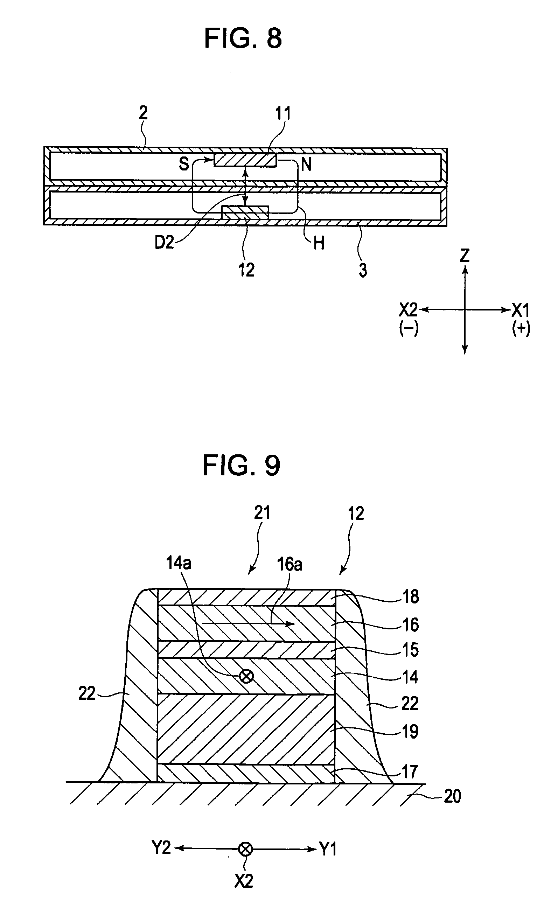

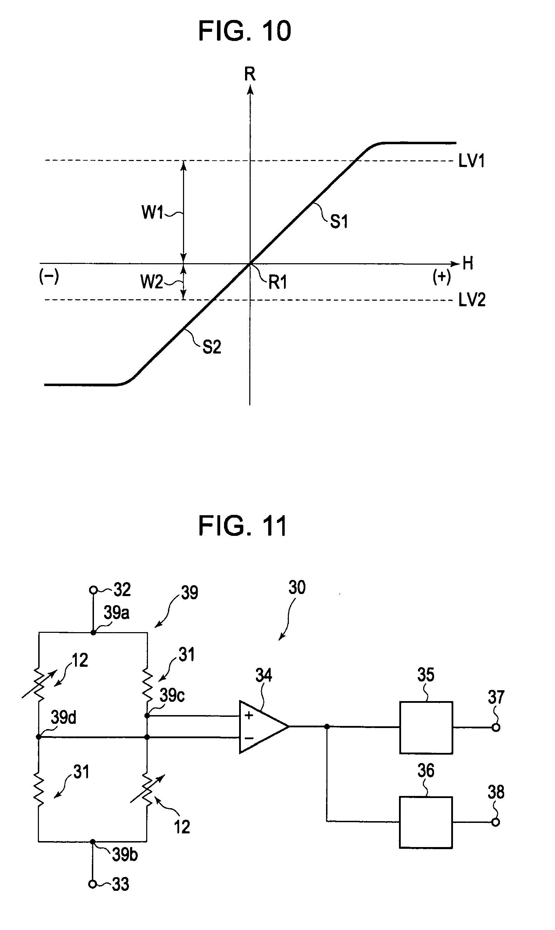

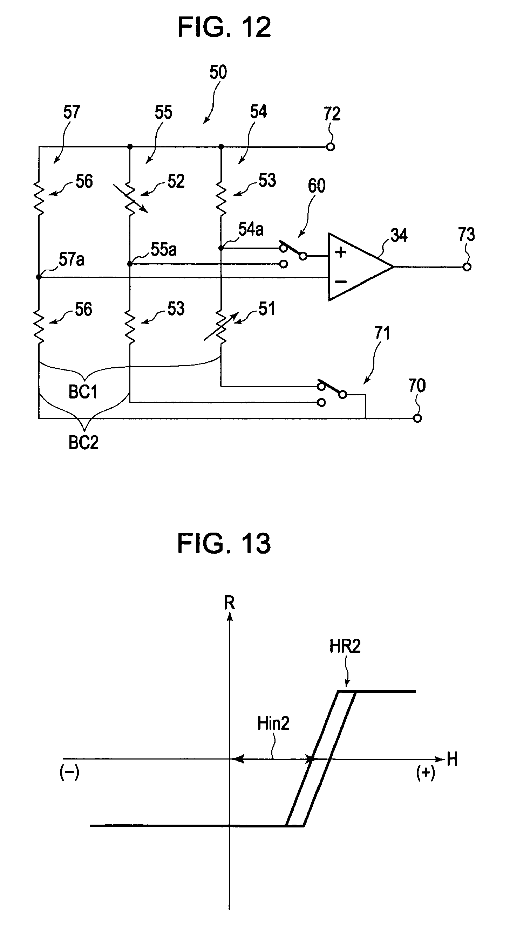

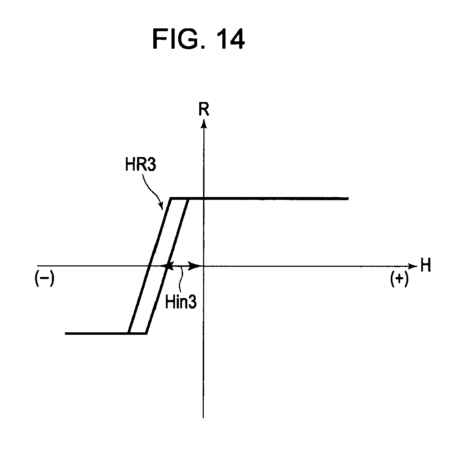

Fig. 1 is a plan view of a flip cellular phone in the open state thereof. Fig. 2 is a perspective view of the flip cellular phone of Fig. 1. Fig. 3 is a side view of the flip cellular phone in the middle of a closing operation arranged from the state of Fig. 2. Fig. 4 is a side view of the flip cellular phone in the fully closed state thereof arranged from the state of Fig. 3. Fig. 5 is a partial sectional view of the flip cellular phone in the closed state thereof taken along line A-A' in Fig. 3 viewed in a direction from arrows. Fig. 6 is a perspective view of the flip cellular phone in the middle of a turnaround operation of a second main body (display case body) arranged from the state illustrated in Fig. 2. Fig. 7 is a plan view of the flip cellular phone with the second main body (display case body) turned around to be in a rear side front position. Fig. 8 is a partial sectional view of the flip cellular phone in a closed state arranged from the state illustrated in Fig. 7, viewed in the same location as in Fig. 5. Fig. 9 is a partial sectional view of a first magnetoresistive effect element (GMR element) for use in embodiments of the present invention. Fig. 10 is a graph (R-H curve) illustrating hysteresis characteristics and threshold value level of the first magnetoresistive effect element for use in embodiments of the present invention. Fig. 11 is a partial circuit diagram of a magnetic detection device of an embodiment of the present invention including the first magnetoresistive effect element. Fig. 12 is a partial circuit diagram of a magnetic detection device including a second magnetoresistive effect element and a third magnetoresistive effect element for use in an embodiment of the present invention. Fig. 13 is a graph (R-H curve) illustrating hysteresis characteristics of the second magnetoresistive effect element. Fig. 14 is a graph (R-H curve) illustrating hysteresis characteristics of the third magnetoresistive effect element.

X1 and X2 directions illustrated in each of the drawings represent a horizontal direction, and Y1 and Y2 directions illustrated in each of the drawings represent a vertical direction, and Z direction in each of the drawings represents a height direction. Any direction is mutually perpendicular to the other two directions.

The flip cellular phone 1 of one embodiment of the present invention illustrated in Figs. 1 and 2 includes a display case body (second main body) 2 and an operation case body (first main body) 3, and a connector 4 connecting the display case body 2 to the operation case body 3.

In the open state of the flip cellular phone 1 illustrated in Fig. 1, a display surface (first surface) 2a having a display screen 5 such as a liquid-crystal display of the display case body 2 and an operation surface (opposing surface) 3a having a variety of operation buttons 6 of the operation case body 3 face externally in the same direction.

The display surface 2a of the display case body 2 also includes a speaker 23, and the operation surface 3a of the operation case body 3 includes a microphone 7.

Referring to Figs. 1 and 2, the connector 4 includes a hinge portion 8 secured to the operation case body 3, and an intermediate portion 10 which is connected to a first rotary shaft 9 extending in a horizontal direction of the hinge portion 8 (X1-X2 direction as indicated) and which is pivoted around the first rotary shaft 9 together with the display case body 2 in an opening and closing direction.

The intermediate portion 10 includes a second rotary shaft 24 arranged at the center of the intermediate portion 10 in the horizontal direction thereof (X1-X2 direction as indicated) and extending in a direction (Y1-Y2 direction as indicated) perpendicular to the rotary shaft 9. The display case body 2 is connected to the second rotary shaft 24. The display case body 2 is supported around the second rotary shaft 24 in a manner such that the display case body 2 is turned around the second rotary shaft 24 to be in a rear side front position. The flip cellular phone 1 can be arranged from a normal use state illustrated in Fig. 1 to a turnaround state illustrated in Fig. 7 by turning the display case body 2 in the rear side front position as illustrated in Fig. 6.

When the longitudinal direction of the flip cellular phone 1 in the open state thereof is aligned in parallel with a vertical direction (along the Y direction as indicated), a single magnet 11 is arranged in the center position of the flip cellular phone 1 in the horizontal direction thereof (X direction as indicated) and in the center line B-B extending in the vertical direction (Y direction as indicated) inside the display case body 2.

The magnet 11 is arranged so that the N pole and the S pole thereof are aligned in the horizontal direction (X1-X2 direction as indicated) as illustrated in Fig. 1.

A first magnetoresistive effect element 12 is arranged in the center line B-B inside the operation case body 3.

In accordance with the present embodiment, the first magnetoresistive effect element 12 is positionally opposed to the magnet 11 in a height direction (Z direction as indicated) in the state that the display case body 2 and the operation case body 3 are closed as illustrated in Fig. 5. It is not necessary that the center of the magnet 11 and the center of the first magnetoresistive effect element 12 be aligned in the height direction. It is sufficient if the first magnetoresistive effect element 12 detects a horizontal magnetic field from the magnet 11. For example, it is acceptable that the first magnetoresistive effect element 12 is slightly deviated in the indicated X1-X2 direction or in the indicated Y1-Y2 direction. As will be described later, a circuit arrangement of one embodiment of the present invention includes two first magnetoresistive effect elements 12 if a bridge circuit is assembled. These first magnetoresistive effect elements 12 are mounted at positions that allow a horizontal magnetic field to be detected.

Referring to Fig. 9, the first magnetoresistive effect element 12 includes a laminate structure including an antiferromagnetic layer 19 made of IrMn, PtMn, or the like, a pinned magnetic layer 14 made of a ferromagnetic material such as NiFe or CoFe, a non-magnetic intermediate layer 15 made of Cu or the like, and a free magnetic layer 16 made of a ferromagnetic material such as NiFe or CoFe, laminated in that order from a mounting surface 20. In the embodiment illustrated in Fig. 9, a seed layer 17 made of NiFeCr or Cr to regulate crystal alignment is arranged beneath the antiferromagnetic layer 19. The formation of the seed layer 17 is not essential. A protective layer 18 made of Ta or the like is formed on the free magnetic layer 16.

The first magnetoresistive effect element 12 further includes hard bias layers 22 and 22 arranged on both sides of the laminate structure 21 (Y1-Y2 direction as indicated) including the seed layer 17 through the protective layer 18.

Since the antiferromagnetic layer 19 and the pinned magnetic layer 14 are formed in contact with each other in the first magnetoresistive effect element 12, an annealing process in magnetic field causes an exchange-coupling magnetic field (Hex) in the interface between the antiferromagnetic layer 19 and the pinned magnetic layer 14. The magnetization direction 14a of the pinned magnetic layer 14 is thus pinned down to one direction. As illustrated in Fig. 9, the magnetization direction 14a of the pinned magnetic layer 14 is pinned down to the X2 direction as indicated.

On the other hand, the magnetization direction 16a of the free magnetic layer 16 is influenced by a bias magnetic field of the hard bias layers 22 arranged on both sides of the free magnetic layer 16 extending in the Y1-Y2 direction, and is aligned with a direction perpendicular to The magnetization direction 14a of the pinned magnetic layer 14, or aligned with the Y1 direction in Fig. 9. Unlike the pinned magnetic layer 14, the free magnetic layer 16 is not pinned in magnetization, and thus varies in magnetization direction in response to the external magnetic field.

When a horizontal magnetic field H running in parallel with the layer surface of each layer forming the first magnetoresistive effect element 12, out of the external magnetic fields emitted from the magnet 11, works, the magnetization direction 16a of the free magnetic layer 16 varies, and an electrical resistance changes due to the relationship of the magnetization direction 14a of the pinned magnetic layer 14 and the magnetization direction 16a of the free magnetic layer 16. This effect is called as the Giant Magnetoresistive (GMR) effect. To cause the GMR effect, a four layer structure including the four-layer structure of the antiferromagnetic layer 19, the pinned magnetic layer 14, the non-magnetic intermediate layer 15 and the free magnetic layer 16 described above functions as a basic layer structure.

In accordance with one embodiment of the present invention, the X1 direction is defined as a (+) direction and the X2 direction is defined as a (-) direction. If the horizontal magnetic field H in the X1 direction, i.e., in the (+) direction acts on the first magnetoresistive effect element 12, the magnetization direction 16a of the free magnetic layer 16 changes to that direction. The magnetization direction 16a of the free magnetic layer 16 and the magnetization direction 14a of the pinned magnetic layer 14 become anti-parallel to each other from the mutually perpendicular state thereof. As illustrated in Fig. 10, a resistance value R of the first magnetoresistive effect element 12 increases. On the other hand, if the horizontal magnetic field H in the X2 direction, i.e., in the (-) direction acts on the first magnetoresistive effect element 12, the magnetization direction 16a of the free magnetic layer 16 changes to that direction. The magnetization direction 16a of the free magnetic layer 16 and the magnetization direction 14a of the pinned magnetic layer 14 become parallel to each other from the mutually perpendicular state thereof. As illustrated in Fig. 10, the resistance value R of the first magnetoresistive effect element 12 decreases.

With reference to Fig. 10, the hysteresis curve of the first magnetoresistive effect element 12 is linear rather than a loop as described later with reference to Figs. 13 and 14. This is because a bias magnetic field is applied on the free magnetic layer 16 as illustrated in Fig. 9.

In accordance with the present embodiment, the first magnetoresistive effect element 12 is a tunneling magnetoresistive effect element based on the tunneling effect with the non-magnetic intermediate layer 15 made of an insulator such as Al-O or Ti-O. The tunneling magnetoresistive effect element also detects a horizontal magnetic field H.

The circuit structure of a magnetic detection device 30 of one embodiment of the present invention is illustrated in Fig. 11. Two first magnetoresistive effect elements 12 are used in the magnetic detection device 30, and the first magnetoresistive effect elements 12 are respectively connected to fixed resistance elements 31. The four elements thus form a bridge circuit 39. Referring to Fig. 11, one junction 39a connecting two serial circuits in parallel is connected to an input terminal 32 while the other junction 39b is connected to a ground terminal 33. Two output pickup points 39c and 39d of the bridge circuit are connected to a differential amplifier 34. The differential amplifier 34 is connected to two comparison circuits (comparators) 35 and 36. The comparison circuits 35 and 36 are respectively connected to a first output terminal 37 and a second output terminal 38.

A first threshold value level (voltage value) LV1 is set in the first comparison circuit 35. If a voltage value higher than the threshold value level LV1 is input, an ON signal is generated. If a voltage value lower than the threshold value level LV1 is input, an OFF signal is generated. Each signal is then output from the first output terminal 37. On the other hand, a second threshold value level (voltage value) LV2 is set in the second comparison circuit 36. If a voltage value lower than the threshold value level LV2, an ON signal is generated. If a voltage value higher than the threshold value level LV2 is input, an OFF signal is generated. Each signal is output from the second output terminal 38.

Fig. 10 illustrates the threshold value levels LV1 and LV2. The threshold value levels LV1 and LV2 are set by voltage value in the comparator circuits 35 and 36. Referring to Fig. 10, the voltage value is converted into the resistance value R of the first magnetoresistive effect element 12 and then plotted.

The fixed resistance element 31 illustrated in Fig. 11 is made of the same material layers as the laminate structure 21 of the first magnetoresistive effect element 12 illustrated in Fig. 9 except the lamination order of the layers. The fixed resistance element 31 includes the free magnetic layer 16 and the non-magnetic intermediate layer 15 illustrated in Fig. 9 laminated in reverse order, namely, includes a laminate structure of the antiferromagnetic layer 19, the pinned magnetic layer 14, the free magnetic layer 16 and the non-magnetic intermediate layer 15 laminated upward from the bottom of the structure. The free magnetic layer 16 formed in contact with the pinned magnetic layer 14 functions no longer as a free magnetic layer having magnetization thereof varying in response to the external magnetic field, but is magnetization pinned as the pinned magnetic layer 14. The fixed resistance element 31 is free from magnetization variation responsive to the external magnetic field and is not changed in the resistance value thereof.

Since the fixed resistance element 31 is made of the same material layers as the first magnetoresistive effect element 12, the resistance value of the fixed resistance element 31 can be set to be equal to the resistance value of the first magnetoresistive effect element 12 (with no external magnetic field operative in a no-magnetic field state). Variations between the temperature coefficient value (TCR) of the first magnetoresistive effect element 12 and the temperature coefficient value of the fixed resistance element 31 can be controlled.

In accordance with the present embodiment, the horizontal magnetic field H of the magnet 11 does not act on the first magnetoresistive effect element 12 with the display case body 2 and the operation case body 3 opened as illustrated in Figs. 1 and 2 (because of the no-magnetic field state), the resistance value R of the first magnetoresistive effect element 12 is R1 as illustrated in Fig. 10, and the resistance values of the four elements forming the bridge circuit 39 of Fig. 11 are all equal to each other. Median voltages are thus output from the two output pickup points 39c and 39d of the bridge circuit 39, and a difference voltage of 0 (V) is obtained by the differential amplifier 34. The difference voltage is lower than the first threshold value level LV1 and higher than the second threshold value level LV2. The OFF signals are thus output from the first output terminal 37 and the second output terminal 38 via the comparison circuits 35 and 36.

If the display case body 2 and the operation case body 3 are flipped shut as illustrated in Fig. 3 from the state illustrated in Figs. 1 and 2 (a first opening detection), the horizontal magnetic field H in the (+) direction emitted from the magnet 11 gradually acts one the first magnetoresistive effect element 12. The resistance value R of the first magnetoresistive effect element 12 gradually rises along a linear portion S1 at a left-to-right upward slope from the resistance value R1 as illustrated in Fig. 10.

Referring to Fig. 4, the magnet 11 and the first magnetoresistive effect element 12 is placed closest to each other when the display case body 2 and the operation case body 3 are flipped shut completely. The strongest horizontal magnetic field H in the (+) direction is thus applied to the first magnetoresistive effect element 12.

If the resistance value R of the first magnetoresistive effect element 12 rises above the first threshold value level LV1 in the middle of closing the display case body 2 and the operation case body 3 as illustrated in Fig. 10, the difference voltage also rises above the first threshold value level LV1 (voltage value) set in the first comparison circuit 35. The ON signal is thus output from the first output terminal 37. On the other hand, the OFF signal is output from the second output terminal 38.

Next, the display case body 2 is turned around to be in the rear side front position as illustrated in Fig. 6 from the state of Fig. 2, and then flipped open to be in a flat state as illustrated in Fig. 7. The display case body 2 and the operation case body 3 are again flipped shut (in a second opening detection) from the state illustrated in Fig. 7.

Fig. 8 illustrates the display case body 2 and the operation case body 3 in the fully closed state thereof with the rear side of the display case body 2 front. As illustrated in Fig. 8, the horizontal magnetic field H in the (-) direction from the magnet 11 acts on the first magnetoresistive effect element 12. More specifically, the horizontal magnetic field H is reversed in direction in comparison with the horizontal magnetic field H in Fig. 5.

When the display case body 2 and the operation case body 3 are flipped shut as illustrated in Fig. 8 from the state of Fig. 7, the horizontal magnetic field H in the (-) direction emitted from the magnet 11 gradually acts on the first magnetoresistive effect element 12. The resistance value R of the first magnetoresistive effect element 12 gradually falls along a linear portion S2 at a right-to-left downward slope from the resistance value R1 in Fig. 10.

If the resistance value R of the first magnetoresistive effect element 12 falls below the second threshold value level LV2 illustrated in Fig. 10 in the middle of the closing operation of the display case body 2 and the operation case body 3, the difference voltage is also below the second threshold value level LV2 (voltage value) set in the second comparison circuit 36. The ON signal is output from the second output terminal 38. On the other hand, the OFF signal is output from the first output terminal 37.

The circuit illustrated in Fig. 11 includes an unshown clock circuit. The difference voltage from the differential amplifier 34 is alternately input to the first comparison circuit 35 and the second comparison circuit 36 at regular time intervals.

As described above, in the first opening detection in which the display case body 2 and the operation case body 3 are closed with the display case body 2 not turned around, the ON signal is output from the first output terminal 37. In the second opening detection in which the display case body 2 and the operation case body 3 are closed with the display case body 2 turned around, the ON signal is output from the second output terminal 38. This arrangement determines whether the display case body 2 is turned around to be in the rear side front position. In other words, this arrangement determines whether the horizontal magnetic field H in the (+) direction or the horizontal magnetic field H in the (-) direction acts on the first magnetoresistive effect element 12, i.e., determines the direction of the external magnetic field.

Since the magnet 11 is mounted on the back of the display screen 5 of the display case body 2, the closest distances D1 and D2 between the magnet 11 and the first magnetoresistive effect element 12 are different between the first opening detection illustrated in Fig. 5 and the second opening detection illustrated in Fig. 8.

The closest distance D1 in the first opening detection illustrated in Fig. 5 is shorter than the closest distance D2 in the second opening detection illustrated in Fig. 8. As for a maximum magnetic field intensity of the horizontal magnetic field H acting on the first magnetoresistive effect element 12, the horizontal magnetic field H in the (+) direction in Fig. 5 is thus stronger than the horizontal magnetic field H in the (-) direction in Fig. 8.

More specifically, even if an inner angle θ between the display case body 2 and the operation case body 3 is the same from the first opening detection to the second opening detection in the course of closing the display case body 2 and the operation case body 3 as illustrated in Fig. 3, the distance between the magnet 11 and the first magnetoresistive effect element 12 is different. The intensity of the horizontal magnetic field H acting on the first magnetoresistive effect element 12 becomes different between the first opening detection and the second opening detection. If a level difference W1 between the first threshold value level LV1 and a reference level (at the position of the resistance value R1 of the first magnetoresistive effect element 12 in Fig. 10) with no external magnetic field applied on the first magnetoresistive effect element 12 is set to be the same as a level difference W2 between the first threshold value level LV1 and the reference level, the first threshold value level LV1 is exceeded earlier when the horizontal magnetic field H in the (+) direction acts on the first magnetoresistive effect element 12 than when the horizontal magnetic field H in the (-) direction acts on the first magnetoresistive effect element 12. The ON signal is thus output at timings different between the first opening detection and the second opening detection. If the level difference W2 of the second threshold value level LV2 is increased in relation to the first threshold value level LV1, the resistance value R of the first magnetoresistive effect element 12 does not fall below the second threshold value level LV2 even if the horizontal magnetic field H in the (-) direction acts on the first magnetoresistive effect element 12. The ON signal is not appropriately output during the second opening detection.

When the inner angle θ between the display case body 2 and the operation case body 3 in the first opening detection is equalized to the inner angle θ between the display case body 2 and the operation case body 3 in the second opening detection as illustrated in Fig. 10, the level difference W1 of the first threshold value level LV1 is increased for low detection sensitivity as illustrated in Fig. 10 during the detection of the external magnetic field in the (+) direction likely to become a strong horizontal magnetic field H. During the detection of the external magnetic field in the (-) direction likely to become a weaker horizontal magnetic field H than in the (+) direction, the level difference W2 of the second threshold value level LV2 is decreased for high detection sensitivity to be smaller than the level difference W2 as illustrated in Fig. 10. In this way, the ON signal is appropriately output during each of the first opening detection and the second opening detection, and the outputting of the ON signal is adjusted at the same timing, i.e., at the same inner angle θ.

A magnetic detection device 50 illustrated in Fig. 12 employs a magnetoresistive effect element different from the first magnetoresistive effect element 12.

With reference to Fig. 12, two types of magnetoresistive effect elements, namely, a second magnetoresistive effect element 51 and a third magnetoresistive effect element 52, are used. Each of the second magnetoresistive effect element 51 and the third magnetoresistive effect element 52 has the same laminate structure 21 as the first magnetoresistive effect element 12 illustrated in Fig. 8. However, the second magnetoresistive effect element 51 and the third magnetoresistive effect element 52 have no hard bias layer 22.

Fig. 13 illustrates a hysteresis curve of the second magnetoresistive effect element 51. Referring to Fig. 13, the hysteresis curve is a loop and the hysteresis loop HR2 is shifted into the external magnetic field in the (+) direction.

An interlayer coupling magnetic field Hin (hereinafter referred to as a second interlayer coupling magnetic field Hin2) is determined by a magnetic field intensity between the center point of the hysteresis loop HR2 to a zero line of the external magnetic field.

On the other hand, Fig. 14 illustrates a hysteresis curve of the third magnetoresistive effect element 52. Referring to Fig. 14, the hysteresis curve is a loop and the hysteresis loop HR3 is shifted into the external magnetic field in the (-) direction.

An interlayer coupling magnetic field Hin (hereinafter referred to as a third interlayer coupling magnetic field Hin3) is determined by a magnetic field intensity between the center point of the hysteresis loop HR3 to the zero line of the external magnetic field.

The interlayer coupling magnetic fields Hin2 and Hin3 are coupling magnetic fields acting between the pinned magnetic layer 14 and the free magnetic layer 16. For example, the interlayer coupling magnetic fields Hin2 and Hin3 can be shifted into the (+) magnetic field and the (-) magnetic field respectively and can be set in different absolute values thereof, by adjusting appropriately the thickness of the non-magnetic intermediate layer 15 and a gas flow rate (gas pressure) and a power value in a plasma treatment (PT) performed on the surface of the non-magnetic intermediate layer 15.

Referring to Fig. 12, the second magnetoresistive effect element 51 and the third magnetoresistive effect element 52 are respectively connected in series with fixed resistance elements 53, thereby forming a first serial circuit 54 and a second serial circuit 55, respectively. A third serial circuit 57 is also formed by connecting serially two fixed resistance elements 56.

The first serial circuit 54 and the third serial circuit 57 are connected in parallel, thereby forming a first bridge circuit BC1. The second serial circuit 55 and the third serial circuit 57 are connected in parallel, thereby forming a second bridge circuit BC2.

An intermediate voltage of the third serial circuit 57 composed of the serially connected fixed resistance elements 56 is handled as a reference voltage serving as a common voltage of the first bridge circuit BC1 and the second bridge circuit BC2. A first switch circuit 60 is also included. A first output pickup point 54a of the first serial circuit 26 forming the first bridge circuit BC1 is connected to the differential amplifier 34. A second output pickup point 55a of the second serial circuit 55 forming the second bridge circuit BC2 is connected to the differential amplifier 34. The first switch circuit 60 alternately switches between the connection of the first output pickup point 54a to the differential amplifier 34 and the connection of the second output pickup point 55a to the differential amplifier 34. The differential amplifier 34 is connected to an output terminal 73.

The magnetic detection device 50 of the present embodiment is a magnetic detection device capable of bipolar detection. The third serial circuit 57 is shared as a common circuit by the first bridge circuit BC1 and the second bridge circuit BC2. In comparison with the related art in which two bridge circuits are separately arranged, the number of elements is reduced. More specifically, with reference to Fig. 12, a total of six elements is used with the element count reduced.

The third serial circuit 57 is shared as the common circuit by the first bridge circuit BC1 and the second bridge circuit BC2 in accordance with the present embodiment. A third output pickup point 57a of the third serial circuit 57 is directly connected to one differential amplifier 34. The first switch circuit 60 is thus configured to switch between the connection of the first output pickup point 54a of the first serial circuit 54 to the differential amplifier 34 and the connection of the second output pickup point 55a of the second serial circuit 55 to the differential amplifier 34. The use of the one differential amplifier 34 allows the two detection states to be alternately selected between the detection state of the external magnetic field in the (+) direction with the first bridge circuit BC1 connected to the differential amplifier 34 and the detection state of the external magnetic field in the (-) direction with the second bridge circuit BC2 connected to the differential amplifier 34. Such a simple circuit structure allows the differential amplifier 34 to obtain the difference voltage from both the first bridge circuit BC1 and the second bridge circuit BC2.

Since the second magnetoresistive effect element 51 in the first bridge circuit BC1 changes the resistance thereof in response to the horizontal magnetic field H in the (+) direction, the first opening detection between the display case body 2 and the operation case body 3 can be performed with the display case body 2 not turned around having the external magnetic field in the (+) direction acting thereon. On the other hand, the third magnetoresistive effect element 52 in the second bridge circuit BC2 changes the resistance thereof in response to the horizontal magnetic field H in the (-) direction, the second opening detection between the display case body 2 and the operation case body 3 can be performed with the display case body 2 turned around having the external magnetic field in the (-) direction acting thereon.

As previously discussed with reference to Figs. 5 and 8, even if the inner angle θ between the display case body 2 and the operation case body 3 remains the same during the first opening detection and during the second opening detection, the magnetic field intensity of the horizontal magnetic field H in the (+) direction acting on the first magnetoresistive effect element 12 is different from the magnetic field intensity of the horizontal magnetic field H in the (-) direction acting on the first magnetoresistive effect element 12. In order to output the ON and OFF signals at the same timing during the first opening detection and the second opening detection, the absolute value of the second interlayer coupling magnetic field Hin2 of the second magnetoresistive effect element 51 is set to be different from the absolute value of the third interlayer coupling magnetic field Hin3 of the third magnetoresistive effect element as illustrated in Figs. 13 and 14. More specifically, the absolute value of the second interlayer coupling magnetic field Hin2 of the second magnetoresistive effect element is set to be larger than the absolute value of the third interlayer coupling magnetic field Hin3 of the third magnetoresistive effect element. The second magnetoresistive effect element 51 needs a larger external magnetic field to result in the same resistance change as the third magnetoresistive effect element 52 (the second magnetoresistive effect element 51 is set to have lower magnetic field detection sensitivity than the third magnetoresistive effect element 52).

And when the inner angle θ between the display case body 2 and the operation case body 3 remains unchanged from the first opening detection to the second opening detection, the external magnetic field in the (+) direction more greatly acts on the first magnetoresistive effect element 12 than the external magnetic field in the (-) direction. By adjusting the interlayer coupling magnetic fields Hin2 and Hin3, the ON signal is properly output during the first opening detection and during the second opening detection. At the same timing, i.e., at the same inner angle θ, the ON signal is adjusted to output.

In order for the magnetic detection device 50 of Fig. 12 to determine the direction of the external magnetic field, the switching operation performed by the first switch circuit 60 is detected, and an output signal then obtained is used to determine the direction of the external magnetic field. Referring to Fig. 12, the connection of the first bridge circuit BC1 to the differential amplifier 34 is detected, and if the signal then obtained is the ON signal, the first opening detection is determined to be operative. The connection of the second bridge circuit BC2 to the differential amplifier 34 is detected in response to the switching operation of the first switch circuit 60. If the signal then obtained is the ON signal, the second opening detection is determined to be operative.

In accordance with the embodiment of Fig. 12, a second switch circuit 71 is arranged. The second switch circuit 71 switches the connection of the ground terminal 70 to the first serial circuit 54 and the connection of the ground terminal 70 to the second serial circuit 55.

When the first switch circuit 60 connects the first bridge circuit BC1 to the differential amplifier 34, the second switch circuit 71 connects the first serial circuit 54 to the ground terminal 70. When the first switch circuit 60 connects the second bridge circuit BC2 to the differential amplifier 34, the second switch circuit 71 connects the second serial circuit 55 to the ground terminal 70. When the first bridge circuit BC1 is connected to the differential amplifier 34 in this way, no current flows through the second serial circuit 55. When the second bridge circuit BC2 is connected to the differential amplifier 34, no current flows through the first serial circuit 54. Power consumption is thus reduced, and the detection sensitivity is increased.

The second switch circuit 71 may be arranged between an input terminal 72 and the first serial circuit 54 and the input terminal 72 and the second serial circuit 55.

The magnetic detection device of the present embodiment includes the magnetoresistive effect element based on the magnetoresistive effect that an electrical resistance of the element varies in response to an external magnetic field, and the common circuit unit connected to the magnetoresistive effect element and enabled to detect both an external magnetic field in a (+) direction and an external magnetic field in a (-) direction opposite to the (+) direction in response to a change in the electrical resistance.

In the related art, a magnetic detection element for detection of the external magnetic field in the (+) direction (such as a Hall element) and a magnetic detection element for detection of the external magnetic field in the (-) direction (such as a Hall element) are separately prepared and circuits respectively connected to the magnetic detection elements for generating magnetic detection signals are separately arranged. In accordance with the present embodiment, the use of the common circuit unit suffices. The magnetic detection device enabled to performed bipolar detection with a circuit arrangement simpler than the counterpart in the related art is thus provided. The magnetic detection device is also miniaturized.

The element count is four in the example of Fig. 4 and six in the example of Fig. 12. The present embodiment includes the bridge circuit. A single serial circuit only can form a magnetic detection device. In such a case, if the first magnetoresistive effect element 12 illustrated in Fig. 11 is used, the element count is two, i.e., one magnetoresistive effect element and one fixed resistance element.

In accordance with the present embodiment, the magnetoresistive effect element based on the magnetoresistive effect is used, and is free from the Hall element unlike in the related art. A typically used Hall element detects a vertical magnetic field component on the surface of the element and needs to be arranged in the vicinity of a magnetic pole of a magnet. If the external magnetic field in the (+) direction and the external magnetic field in the (-) direction are different in magnetic field intensity, the magnetic field cannot be detected by a single Hall element only. The magnetoresistive effect element of the present embodiment detects a horizontal magnetic field component in parallel with a layer surface, and can also detect a weak external magnetic field. The use of at least one magnetoresistive effect element allows both the external magnetic field in the (+) direction and the external magnetic field in the (-) direction to be detected.

The above-described embodiment employs the GMR element as the magnetoresistive effect element. An AMR element based on the anisotropic magnetoresistance effect may also be used.

In accordance with the present embodiment, in the first opening detection the display case body 2 and the operation case body 3 are closed with the display case body 2 not turned around and in the second opening detection the display body 2 and the operation case body 3 are closed with the display case body 2 turned around. Even if the inner angle θ between the display case body 2 and the operation case body 3 in the first opening detection is the same as the inner angle θ between the display case body 2 and the operation case body 3 in the second opening detection, the distance between the magnet 11 and the magnetoresistive effect element in the first opening detection is different from the distance between the magnet 11 and the magnetoresistive effect element in the second opening detection. In such a case, the detection sensitivity of the external magnetic field in the (+) direction is set to be lower than the detection sensitivity of the external magnetic field in the (-) direction if the external magnetic field in the (+) direction is higher in magnetic field intensity than the external magnetic field in the (-) direction. The magnetic field detection signal is appropriately output in both when the external magnetic field in the (+) direction is operative and when the external magnetic field in the (-) direction is operative. The ON signal and the OFF signal are output at the same timing. For example, as described above, the sensitivity adjustment may be performed by adjusting the threshold value level of the difference voltage or by adjusting the interlayer coupling magnetic field Hin.

In accordance with the present embodiment, the external magnetic field in the (+) direction is operative on the magnetoresistive effect element during the first opening detection and the external magnetic field in the (-) direction is operative on the magnetoresistive effect element during the second opening detection. The orientation of the magnet 11 may be changed so that the external magnetic field in the (-) direction is operative on the magnetoresistive effect element during the first opening detection and so that the external magnetic field in the (+) direction is operative on the magnetoresistive effect element during the second opening detection.

The (+) direction is the X1 direction and the (-) direction is the X2 direction. Alternatively, the orientation of the magnet 11 may be changed so that the Y1 direction is set to be the (+) direction and so that Y2 direction is set to be the (-) direction.

The embodiment as the flip cellular phone has been discussed. The embodiment of the present invention may be applied to any electronic apparatus such as a game playing machine as long as the electronic apparatus includes a first main body and a second main body with the first main body connected to the second main body in a manner such that the first main body and the second main body are flipped open and shut and with the second main body supported in a manner such that the second main body is enabled to be turned around to be in the rear side front position.

### Brief Description of the Drawings

[Fig. 1] Fig. 1 is a plan view of the flip cellular phone in the open state thereof.
[Fig. 2] Fig. 2 is a perspective view of the flip cellular phone illustrated in Fig. 1.
[Fig. 3] Fig. 3 is a side view of the flip cellular phone in the middle of a closing operation from the state illustrated in Fig. 2.
[Fig. 4] Fig. 4 is a side view of the flip cellular phone in a fully closed state shifted from the state illustrated in Fig. 3.
[Fig. 5] Fig. 5 is a partial sectional view of the flip cellular phone taken along line A-A and viewed from arrows in Fig. 4.
[Fig. 6] Fig. 6 is a perspective view of the flip cellular phone in the middle of a turnaround operation of a second main body (display case body) from the state illustrated in Fig. 2.
[Fig. 7] Fig. 7 is a plan view of the flip cellular phone with the second main body (display case body) turned around to be in the rear side front position.
[Fig. 8] Fig. 8 is a partial sectional view of the flip cellular phone in the fully closed state thereof changed from the state illustrated in Fig. 7, and viewed from the same location as in Fig. 5.
[Fig. 9] Fig. 9 is a partial sectional view of a first magnetoresistive effect element (GMR element) for use in embodiments of the present invention.
[Fig. 10] Fig. 10 is a graph (R-H curve) illustrating hysteresis characteristics and threshold value level of the first magnetoresistive effect element for use in embodiments of the present invention.
[Fig. 11] Fig. 11 is a partial circuit diagram of a magnetic detection device of a first embodiment of the present invention including the first magnetoresistive effect element.
[Fig. 12] Fig. 12 is a partial circuit diagram of a magnetic detection device including a second magnetoresistive effect element and a third magnetoresistive effect element for use in a second embodiment of the present invention.
[Fig. 13] Fig. 13 is a graph (R-H curve) illustrating hysteresis characteristics of the second magnetoresistive effect element.
[Fig. 14] Fig. 14 is a graph (R-H curve) illustrating hysteresis characteristics of the third magnetoresistive effect element.

### Reference Numerals

- 1: Flip cellular phone
- 2: Display case body
- 3: Operation case body
- 4: Connector
- 5: Display screen
- 6: Operation button
- 8: Hinge portion
- 10: Intermediate portion
- 11: Magnet
- 12: First magnetoresistive effect element
- 14: Pinned magnetic layer
- 15: Non-magnetic intermediate layer
- 16: Free magnetic layer
- 19: Antiferromagnetic layer
- 21: Laminate structure
- 22: Hard bias layer
- 30 and 50: Magnetic detection devices
- 31, 53, and 56: Fixed resistance elements
- 32 and 72: Input terminals
- 33 and 70: Ground terminals
- 34: Differential amplifier
- 35 and 36: First comparison circuits
- 37, 38 and 73: Output terminals
- 39: Bridge circuit
- 51: Second magnetoresistive effect element
- 52: Third magnetoresistive effect element
- 54: First serial circuit
- 55: Second serial circuit
- 57: Third serial circuit
- 60: First switch circuit
- 71: Second switch circuit
- BC1: First bridge circuit
- BC2: Second bridge circuit

## Claims

1. A magnetic detection device comprising a magnetoresistive effect element (12, 51, 52) based on the magnetoresistive effect that an electrical resistance of the element varies in response to an external magnetic field, and
a common circuit unit connected to the magnetoresistive effect element (12, 51, 52) and enabled to detect both an external magnetic field in a (+) direction and an external magnetic field in a (-) direction opposite to the (+) direction in response to a change in the electrical resistance;
wherein the magnetoresistive effect element (12) is a first common magnetoresistive effect element (12) having an electrical resistance changing in response to each of the external magnetic field in the (+) direction and the external magnetic field in the (-) direction, and
wherein a threshold value level of an output needed for the magnetic detection of the external magnetic field in the (+) direction and a threshold value level of an output needed for the magnetic detection of the external magnetic field in the (-) direction are set in the circuit unit;
**characterized in that** a level difference between a reference level of an output in response to no magnetic field state and the threshold value level, of the output needed for the magnetic detection of the external magnetic field in the (+) direction is set to be larger than a level difference between the reference level and the threshold value level of the output needed for the magnetic detection of the external magnetic field in the (-) direction when the maximum magnetic field intensity of the external magnetic field in the (+) direction acting on the first magnetoresistive effect element (12) is higher than the maximum magnetic field intensity of the external magnetic field in the (-) direction acting on the first magnetoresistive effect element (12).

2. The magnetic detection device (30; 50) according to claim 1, wherein when the maximum magnetic field intensity of the external magnetic field in the (+) direction acting on the magnetoresistive effect element (12, 51, 52) is higher than the maximum magnetic field intensity of the external magnetic field in the (-) direction acting on the magnetoresistive effect element (12, 51, 52), a detection sensitivity applied with the external magnetic field in the (+) direction operative is set to be lower than a detection sensitivity applied with the external magnetic field in the (-) direction operative.

3. The magnetic detection device (30; 50) according to claim 1, wherein the magnetoresistive effect elements (12, 51, 52) comprise a second magnetoresistive effect element (51) having an electrical resistance changing in response to the external magnetic field in the (+) direction and a third magnetoresistive effect element (52) having an electrical resistance changing in response to the external magnetic field in the (-) direction, and
wherein the circuit unit detects both the external magnetic field in the (+) direction in response to a change in an electrical resistance of the second magnetoresistive effect element (51) and the external magnetic field in the (-) direction in response to a change in an electrical resistance of the third magnetoresistive effect element (52).

4. The magnetic detection device (30; 50) according to claim 3, wherein each of the second magnetoresistive effect element (51) and the third magnetoresistive effect element (52) has a laminate structure comprising an antiferromagnetic layer (19), a pinned magnetic layer(14), a non-magnetic intermediate layer (15), and a free magnetic layer (16), and
wherein when the maximum magnetic field intensity of the external magnetic field in the (+) direction acting on the second magnetoresistive effect element (51) is higher than the maximum magnetic field intensity of the external magnetic field in the (-) direction acting on the third magnetoresistive effect element (52), the absolute value of an interlayer coupling magnetic field Hin2 acting between the pinned magnetic layer (14) and the free magnetic layer (16) of the second magnetoresistive effect element (51) is set to be larger than the absolute value of an interlayer coupling magnetic field Hin3 acting between the pinned magnetic layer (14) and the free magnetic layer (16) of the third magnetoresistive effect element (52).

5. An electronic apparatus (1) comprising a first main body (3) and a second main body (2), the first main body and the second main body (2) connected to each other in a manner that allows the first and second main bodies (2, 3) to flip open and shut, and the second main body (2) supported in a manner that allows the second main body (2) to be turned around to be in a rear side front position,
wherein a magnet (11) is mounted on one of the first main body (3) and the second main body (2), and the magnetic detection device (30; 50) according to one of claims 1 through 4 is mounted on the other of the first main body (3) and the second main body (2), and
wherein when the first main body (3) and the second main (2) body are flipped shut in a first opening detection with the second main body (2) not turned around, the magnet (11) and the magnetic detection device (30; 50) move closer in distance to each other and the external magnetic field in one of the (+) direction and the (-) direction emitted from the magnet (11) is detected, and when the first main body (3) and the second main body (2) are flipped shut in a second opening detection with the second main body (2) turned around, the magnet (11) and the magnetic detection device (30; 50) move closer in distance to each other and the other external magnetic field in the direction opposite to the direction in the first opening detection emitted from the magnet (11) is detected.

## Patentansprüche

1. Eine Magnet-Detektionsvorrichtung mit einem Magnetwiderstandseffektelement (12, 51, 52), das auf dem Magnetwiderstandseffekt beruht, dass sich ein elektrischer Widerstand des Elements in Reaktion auf ein äußeres Magnetfeld ändert, und
einer gemeinsamen Schaltungseinheit, die mit dem Magnetwiderstandseffektelement (12, 51, 52) verbunden und eingerichtet ist, in Reaktion auf eine Änderung des elektrischen Widerstands sowohl ein äußeres Magnetfeld in einer (+)-Richtung, als auch ein äußeres Magnetfeld in einer (-)-Richtung, die der (+)-Richtung entgegengesetzt ist, zu detektieren;
wobei das Magnetwiderstandseffektelement (12) ein erstes gemeinsames Magnetwiderstandseffektelement (12) ist, das einen elektrischen Widerstand hat, der sich in Reaktion sowohl eines äußeren Magnetfeldes in der (+)-Richtung als auch eines äußeren Magnetfeldes in der (-)-Richtung ändert, und
wobei ein Schwellwertniveau eines Ausgangssignals, das notwendig ist, um das äußere Magnetfeld in der (+)-Richtung zu detektieren, und ein Schwellwertniveau eines Ausgangssignals, das notwendig ist, um das äußere Magnetfeld in der (-)-Richtung zu detektieren, in der Schaltungseinheit festgelegt werden;
**dadurch gekennzeichnet, dass**, wenn die maximale Magnetfeldintensität des äußeren Magnetfeldes in der (+)-Richtung, die auf das erste Magnetwiderstandseffektelement (12) wirkt, größer ist als die maximale Magnetfeldintensität des äußeren Magnetfeldes in der (-)-Richtung, die auf das erste Magnetwiderstandseffektelement (12) wirkt, der Niveauunterschied zwischen einem Referenzniveau eines Ausgangssignals in Reaktion auf einen Zustand ohne magnetisches Feld und dem Schwellwertniveau des Ausgangssignals, das für die magnetische Detektion des äußeren Magnetfeldes in der (+)-Richtung notwendig ist, größer festgelegt wird als der Niveauunterschied zwischen dem Referenzniveau und dem Schwellwertniveau des Ausgangssignals, das für die magnetische Erkennung des äußeren Magnetfelds in der (-)-Richtung notwendig ist.

2. Die Magnet-Detektionsvorrichtung (30; 50) nach Anspruch 1,
wobei, wenn die maximale Magnetfeldintensität des äußeren Magnetfeldes, das in der (+)-Richtung auf das Magnetwiderstandseffektelement (12, 51, 52) wirkt, größer ist als die maximale Magnetfeldintensität des äußeren Magnetfeldes, das in der (-)-Richtung auf das Magnetwiderstandseffektelement (12, 51, 52) wirkt, eine Detektionsempfindlichkeit, die angewandt wird, wenn das äußere Magnetfeld in der (+)-Richtung wirkt, kleiner gewählt wird als eine Detektionsempfindlichkeit, die angewandt wird, wenn das äußere Magnetfeld in der (-)-Richtung wirkt.

3. Die Magnet-Detektionsvorrichtung g (30, 50) nach Anspruch 1,
wobei die Magnetwiderstandseffektelemente (12, 51, 52) ein zweites Magnetwiderstandseffektelement (51) mit einem elektrischen Widerstand, der sich in Reaktion auf ein äußeres Magnetfeld in der (+)-Richtung ändert, und ein drittes Magnetwiderstandseffektelement (52) mit einem elektrischen Widerstand, der sich in Reaktion auf das äußere Magnetfeld in der (-)-Richtung ändert, umfassen, und
wobei die Schaltungseinheit sowohl das äußere Magnetfeld in der (+)-Richtung in Reaktion auf eine Änderung eines elektrischen Widerstandes des zweiten Magnetwiderstandseffektelements (51) als auch das äußere Magnetfeld in der (-)-Richtung in Reaktion auf eine Änderung des elektrischen Widerstandes des dritten Magnetwiderstandseffektelements (52) detektiert.

4. Die Magnet-Detektionsvorrichtung (30; 50) nach Anspruch 3,
wobei sowohl das zweite Magnetwiderstandseffektelement (51) als auch das dritte Magnetwiderstandseffektelement (52) eine Schichtstruktur haben, die eine antiferromagnetische Schicht (19), eine gepinnte magnetische Schicht (40), eine nichtmagnetische Zwischenschicht (15) und eine freie magnetische Schicht (16) umfasst, und
wobei, wenn die maximale Magnetfeldintensität des äußeren Magnetfeldes, das in der (+)-Richtung auf das zweite Magnetwiderstandseffektelement (51) wirkt, größer als die maximale Magnetfeldintensität des äußeren Magnetfeldes, das in der (-)-Richtung auf das dritte Magnetwiderstandseffektelement (52) wirkt, ist, der Absolutwert eines Zwischenschicht-Kopplungsmagnetfeldes (Hin2), das zwischen der gepinnten Magnetschicht (14) und der freien Magnetschicht (16) des zweiten Magnetwiderstandseffektelement (51) wirkt, größer gewählt wird als der Absolutwert eines Zwischenschicht-Kopplungsmagnetfeldes (Hin3), das zwischen der gepirinten Magnetschicht (14) und der freien Magnetschicht (16) des dritten Magnetwiderstandseffektelement (52) wirkt.

5. Eine elektronische Vorrichtung (1) mit einem ersten Hauptkörper (3) und einem zweiten Hauptkörper (2),
wobei der erste Hauptkörper und der zweite Hauptkörper (2) auf eine Art und Weise miteinander verbunden sind, die es dem ersten und dem zweiten Hauptkörper (2, 3) ermöglicht, auf und zu zu klappen, wobei der zweite Hauptkörper (2) in einer Art und Weise gelagert ist, die es dem zweiten Hauptkörper (2) ermöglicht, sich so umzudrehen, dass er in einer Position mit der Rückseite nach vorne ist,
wobei an einem von dem ersten Hauptkörper (3) und dem zweiten Hauptkörper (2) ein Magnet (11) angebracht ist, und an dem anderen von dem ersten Hauptkörper (3) und dem zweiten Hauptkörper (2) die Magnet-Detektionsvorrichtung (30; 50) nach einem derAnsprüche 1 bis 4 angebracht ist, und
wobei sich, wenn der erste Hauptkörper (3) und der zweite Hauptkörper (2) zusammengeklappt werden, in einer ersten Öffnungserkennung, bei der der zweite Hauptkörper (2) nicht umgedreht ist, der Magnet (11) und die Magnet-Detektionsvorrichtung (30; 50) einander annähern und das äußere Magnetfeld, das entweder in der (+)-Richtung oder in der (-)-Richtung von dem Magneten (11) ausgesendet wird, detektiert wird, und
wobei sich, wenn der erste Hauptkörper (3) und der zweite Hauptkörper (2) zusammengeklappt werden, in einer zweiten Öffnungserkennung, bei der der zweite Hauptkörper (2) umgedreht ist, der Magnet (11) und die Magnet-Detektionsvorrichtung (30; 50) einander annähern und das andere äußere Magnetfeld, das von dem Magneten (11) in einer Richtung ausgesendet wird, die der Richtung bei der ersten Öffnungserkennung entgegengesetzt ist, detektiert wird.

## Revendications

1. Dispositif de détection magnétique comprenant un élément à effet magnétorésistif (12, 51, 52) basé sur l'effet magnétorésistif selon lequel une résistance électrique de l'élément varie en réponse à un champ magnétique externe, et
une unité de circuit commun connectée à l'élément à effet magnétorésistif (12, 51, 52) et apte à détecter à la fois un champ magnétique externe dans une direction (+) et un champ magnétique externe dans une direction (-) opposée à la direction (+) en réponse à une variation de la résistance électrique ;
dans lequel l'élément à effet magnétorésistif (12) est un premier élément à effet magnétorésistif commun (12) ayant une résistance électrique qui varie en réponse à chacun des champ magnétique externe dans la direction (+) et champ magnétique externe dans la direction (-), et
dans lequel un niveau de valeur de seuil d'une sortie nécessaire pour la détection magnétique du champ magnétique externe dans la direction (+) et un niveau de valeur de seuil d'une sortie nécessaire pour la détection magnétique du champ magnétique externe dans la direction (-) sont réglés dans l'unité de circuit ;
**caractérisé en ce qu'**une différence de niveau entre un niveau de référence d'une sortie en réponse à un état d'absence de champ magnétique et le niveau de valeur de seuil de la sortie nécessaire pour la détection magnétique du champ magnétique externe dans la direction (+) est choisie de façon à être supérieure à une différence de niveau entre le niveau de référence et le niveau de valeur de seuil de la sortie nécessaire pour la détection magnétique du champ magnétique externe dans la direction (-) quand l'intensité de champ magnétique maximum du champ magnétique externe dans la direction (+) agissant sur le premier élément à effet magnétorésistif (12) est supérieure à l'intensité de champ magnétique maximum du champ magnétique externe dans la direction (-) agissant sur le premier élément à effet magnétorésistif (12).

2. Dispositif de détection magnétique (30 ; 50) selon la revendication 1, dans lequel, quand l'intensité de champ magnétique maximum du champ magnétique externe dans la direction (+) agissant sur l'élément à effet magnétorésistif (12, 51, 52) est supérieure à l'intensité de champ magnétique maximum du champ magnétique externe dans la direction (-) agissant sur l'élément à effet magnétorésistif (12, 51, 52), une sensibilité de détection appliquée avec le champ magnétique externe dans la direction (+) opérante est choisie de façon à être inférieure à une sensibilité de détection appliquée avec le champ magnétique externe dans la direction (-) opérante.

3. Dispositif de détection magnétique (30 ; 50) selon la revendication 1, dans lequel les éléments à effet magnétorésistif (12, 51, 52) comprennent un deuxième élément à effet magnétorésistif (51) ayant une résistance électrique, qui varie en réponse au champ magnétique externe dans la direction (+) et un troisième élément à effet magnétorésistif (52) ayant une résistance électrique qui varie en réponse au champ magnétique externe dans la direction (-), et
dans lequel l'unité de circuit détecte à la fois le champ magnétique externe dans la direction (+) en réponse à une variation d'une résistance électrique du deuxième élément à effet magnétorésistif (51) et le champ magnétique externe dans la direction (-) en réponse à une variation d'une résistance électrique du troisième élément à effet magnétorésistif (52).

4. Dispositif de détection magnétique (30 ; 50) selon la revendication 3, dans lequel chacun des deuxième élément à effet magnétorésistif (51) et troisième élément à effet magnétorésistif (52) a une structure stratifiée comprenant une couche antiferromagnétique (19), une couche magnétique ancrée (14), une couche intermédiaire non magnétique (15) et une couche magnétique libre (16), et
dans lequel, quand l'intensité de champ magnétique maximum du champ magnétique externe dans la direction (+) agissant sur le deuxième élément à effet magnétorésistif (51) est supérieure à l'intensité de champ magnétique maximum du champ magnétique externe dans la direction (-) agissant sur le troisième élément à effet magnétorésistif (52), la valeur absolue d'un champ magnétique de couplage entre couches Hin2 agissant entre la couche magnétique ancrée (14) et la couche magnétique libre (16) du deuxième élément à effet magnétorésistif (51) est choisie pour être supérieure à la valeur absolue d'un champ magnétique de couplage entre couches Hin3 agissant entre la couche magnétique ancrée (14) et la couche magnétique libre (16) du troisième élément à effet magnétorésistif (52).

5. Appareil électronique (1) comprenant un premier corps principal (3) et un deuxième corps principal (2), le premier corps principal et le deuxième corps principal (2) étant connectés entre eux d'une manière qui permet aux premier et deuxième corps (2, 3) de s'ouvrir et se fermer de façon articulée, et le deuxième corps principal (2) étant supporté d'une manière qui permet au deuxième corps principal (2) d'être retourné pour présenter sa face arrière,
dans lequel un aimant (11) est monté sur l'un des premier (3) et deuxième (2) corps principaux, et le dispositif de détection magnétique (30 ; 50) selon l'une des revendications 1 à 4 est monté sur l'autre des premier (3) et deuxième (2) corps principaux, et
dans lequel, quand on ferme le premier corps principal (3) et le deuxième corps principal (2) dans une première détection d'ouverture avec le deuxième corps principal (2) non retourné, l'aimant (11) et le dispositif de détection magnétique (30 ; 50) se rapprochent l'un de l'autre et le champ magnétique externe dans l'une des directions (+) et (-) émis par l'aimant (11) est détecté, et quand on ferme le premier corps principal (3) et le deuxième corps principal (2) dans une deuxième détection d'ouverture avec le deuxième corps principal (2) retourné, l'aimant (11) et le dispositif de détection magnétique (30 ; 50) se rapprochent l'un de l'autre et l'autre champ magnétique externe dans la direction opposée à la direction dans la première détection d'ouverture émis par l'aimant (11) est détecté.
